# EUROPEAN PATENT APPLICATION

(11) **EP 1 731 567 A1**
(43) Date of publication of application: **13.12.2006**
(21) Application number: 06252695.9
(22) Date of filing: 24.05.2006
(51) Int. Cl.: C08L 43/04, C08L 83/04, C08G 65/00

(54) **Fluorine-containing material**

(30) Priority: 25.05.2005 JP 2005152765
(71) Applicant: Shin-Etsu Chemical Co., Ltd., Chiyoda-ku, Tokyo (JP)
(72) Inventor: Kishita, Hirofumi c/o Shin-Etsu Chemical Co., Ltd., Gunma-ken (JP); Sato, Shinichi c/o Shin-Etsu Chemical Co., Ltd., Gunma-ken (JP)
(74) Representative: Stoner, Gerard Patrick

(57) **Abstract**

A rubber or gel material in the form of a fluoroelastomer obtained by crosslinking of a curable composition comprising a linear perfluoropolyether dialkenyl compound, a fluorinated organopolysiloxane having at least three silicon-bonded hydrogen atoms, and a hydrosilylation catalyst has a swelling degree of up to 20% in dimethyl ether. The rubber or gel material has improved dimethyl ether resistance as well as heat resistance and freeze resistance.

## Description

This invention relates to fluorine-containing materials having heat resistance and freeze resistance as well as improved resistance to dimethyl ether, and articles comprising the same, and use thereof.

### BACKGROUND

Dimethyl ether (often abbreviated as DME, hereinafter) having the chemical formula: CH₃OCH₃ is generally produced by way of synthetic gases originating from natural gas, coal, biomass and the like. DME has already been utilized as aerosol propellant and is expected to find use as power plant fuel and Diesel engine fuel based on the fact that DME generates no sulfur oxide because it is sulfur-free, and DME is unlikely to generate particulate matter because it has a higher cetane number than light oil and is an oxygen-containing fuel.

However, DME has different chemical properties than ordinary hydrocarbon fuels. DME is more penetrative to and more likely to swell and dissolve organic compounds including rubbers and plastics. For the sealing of ordinary fuels, sealing materials based on such rubbers as NBR, hydrogenated NBR, IIP and FKM (fluororubber) are used in the prior art. With respect to DME, these rubber-based sealing materials have a high swelling degree of 30% or greater and an increased likelihood of leakage, indicating an insufficient function as sealant. See Journal of Pressurized Gas, Vol. 42, No. 2, 34-38.

Rubber materials and members which are known to be resistant to DME and LPG include fluoroelastomer compositions comprising a fluoro compound having a divalent perfluoropolyether or divalent perfluoroalkylene structure in the backbone and at least two alkenyl groups (capable of addition reaction with hydrosilyl groups) at ends or side chains, and a polymer having in a molecule at least two hydrosilyl groups capable of addition reaction with the alkenyl groups, the compositions being crosslinked into fluoroelastomers having improved DME resistance. See JP-A 2004-137390.

For practical use as fuel-related sealing materials in automobiles, power plants and chemical plants, heat resistance at temperatures above 180°C and freeze resistance at temperatures below -30°C are also required. FFKM (perfluoro rubber) which is a perfluoroelastomer having the best function among rubber materials has good heat resistance, a low swelling degree in DME and good sealing performance, but poor freeze resistance as demonstrated by a TR-10 temperature of -5°C. This poor freeze resistance combined with expensiveness substantially limits the application of FFKM.

An object of the invention is to provide a fluorine-containing material in the form of a rubber or gel material based on perfluoropolyether structure, having improved DME resistance as well as heat resistance and freeze resistance.

The above and other objects are attained by a rubber or gel material obtained by crosslinking through hydrosilylation of a linear polyfluoro compound containing two alkenyl groups per molecule and having a perfluoropolyether structure in its backbone, represented by the formula (1), and a fluorinated organopolysiloxane having at least two hydrogen atoms directly bonded to silicon atoms per molecule, and having a swelling degree of up to 20% in dimethyl ether.

The present invention provides a fluorine-containing material consisting of a rubber or gel obtained by crosslinking through hydrosilylation of (A) a linear polyfluoro compound containing two alkenyl groups per molecule and having a perfluoropolyether structure in its backbone, represented by the formula (1), and (B) a (preferably fluorinated) organopolysiloxane containing at least three hydrogen atoms directly bonded to silicon atoms per molecule, and preferably having a swelling degree in DME of up to 20%. 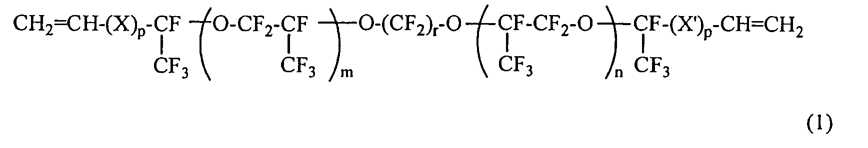 Herein X is -CH₂- or -Y-NR-CO- wherein Y is -CH₂- or a dimethylphenylsilylene group of the following structural formula (Z): 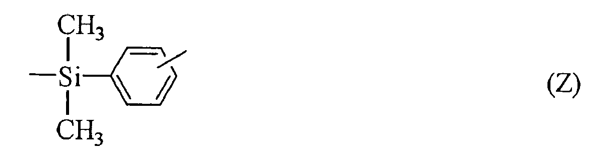 (inclusive of o-, m- and p-positions) and R is methyl or phenyl; X' is -CH₂- or -CO-NR'-Y'- wherein Y' is -CH₂- or a dimethylphenylsilylene group of the following structural formula (Z'): 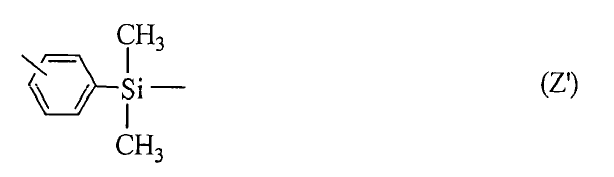 (inclusive of o-, m- and p-positions) and R' is methyl or phenyl; the letter p is independently 0 or 1, r is an integer of 2 to 6, and m and n each are an integer of 0 to 200.

In this case, it is preferable that the rubber or fluoroelastomer undergoes a change of tensile strength of up to 10% in a 200°C/100 hour heating test.

The present invention also provides a fluorine-containing material consisting of a gel material obtained by crosslinking of a curable composition and preferably having a swelling degree of up to 20% in dimethyl ether,
said curable composition comprising
(A) a linear polyfluoro compound containing two alkenyl groups per molecule and having a perfluoropolyether structure in its backbone, represented by the formula (1): 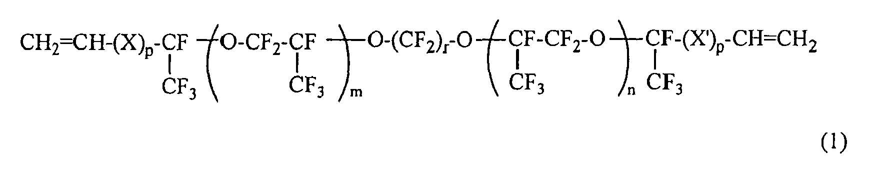 wherein X is -CH₂- or -Y-NR-CO- wherein Y is -CH₂- or a dimethylphenylsilylene group of the following structural formula (Z): 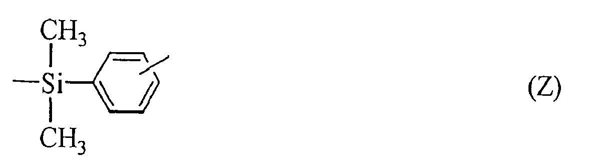 (inclusive of o-, m- and p-positions) and R is methyl or phenyl,
   X' is -CH₂- or -CO-NR'-Y'- wherein Y' is -CH₂- or a dimethylphenylsilylene group of the following structural formula (Z'): 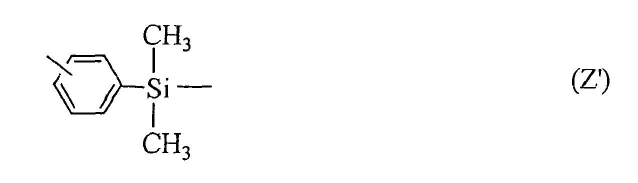 (inclusive of o-, m- and p-positions) and R' is methyl or phenyl,
   p is independently 0 or 1, r is an integer of 2 to 6, and m and n each are an integer of 0 to 200,
(B) a (preferably fluorinated) organopolysiloxane having at least three hydrogen atoms directly bonded to silicon atoms in a molecule,
(C) a hydrosilylation catalyst, and
(D) a polyfluoromonoalkenyl compound having the general formula (3):

   Rf¹-(X')ₚ-CH=CH₂ (3)

   wherein X' and p are as defined above, and Rf¹ has the formula: F-[CF(CF₃)CF₂O]_{w}-CF(CF₃)- wherein w is an integer of 1 to 500.
   The curable composition may further comprise
(E) at least one linear polyfluoro compound selected from compounds having the general formula (4):

   A-O-(CF₂CF₂CF₂O)_{d}-A (4)

   wherein A is a group of the formula: CₑF₂ₑ₊₁-, d is an integer of 1 to 500, and e is an integer of 1 to 3, and compounds having the general formula (5):

   A-O-(CF₂O)_{f}(CF₂CF₂O)ₕ-A (5)

   wherein A is as defined above and f and h each are an integer of 1 to 300.

The present invention also provides an article composed of the above fluorine-containing material for use in automobiles, chemical plants, ink jet printers, semiconductor manufacturing lines, analytical or scientific instruments, medical equipment, aircraft or fuel cells.

Also provided a pressure sensor for use in automobiles comprising a sensor section for detecting a pressure and generating an electric signal in response to the detected pressure value, and a protective member with chemical resistance covering the sensor section for protection, said protective member comprising the fluorine-containing material.

A fuel-related sealing material composed of the fluorine-containing material for use in automobiles, chemical plants, fuel storage, fuel transportation, fuel cells, power generators, household appliances, and aircraft, as well as a fuel-related sealing material composed of the fluorine-containing material which is a diaphragm, valve, O-ring, oil seal, gasket or packing are also provided.

The curable compositions herein include novel compositions which themselves are a further aspect of the invention. Another aspect of the invention is the use of articles consisting of or comprising the cured compositions in fuel-contacting uses, especially with gasoline (petrol) or DME fuel. Methods comprising curing the compositions to form gel or rubber articles are a further aspect.

DME swelling degree and tensile strength/heating test parameters used herein can be determined in accordance with the JIS standards specified below.

### BENEFITS OF THE INVENTION

Using the curable fluoropolyether rubber or gel composition of the invention as a curable composition, a rubber or gel material (fluorine-containing material) having good or improved DME resistance as well as heat resistance and freeze resistance is obtained.

### FURTHER EXPLANATIONS, OPTIONS AND PREFERENCES

### Component A

Component (A) of the curable composition or the curable perfluoropolyether rubber or gel compositions according to the invention is a linear fluoropolyether compound containing two alkenyl groups per molecule and having a perfluoropolyether structure in its backbone, as represented by formula (1).

The linear fluoropolyether compound of formula (1) should desirably have a weight-average molecular weight (Mw) of 2,000 to 100,000, and more preferably 4,000 to 50,000, as measured by gel permeation chromatography (GPC) using polystyrene standards.

Illustrative examples of the linear fluoropolyether compound of formula (1) are given below. 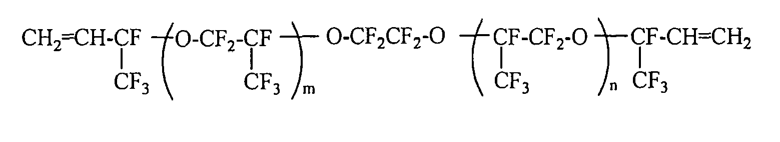 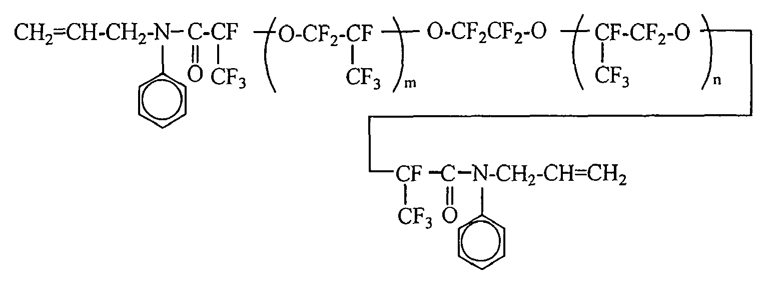 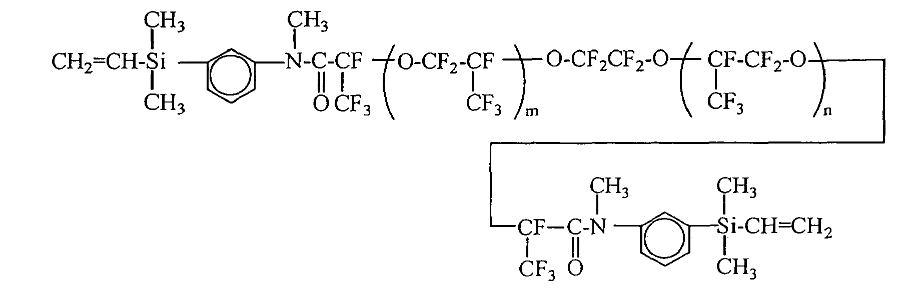 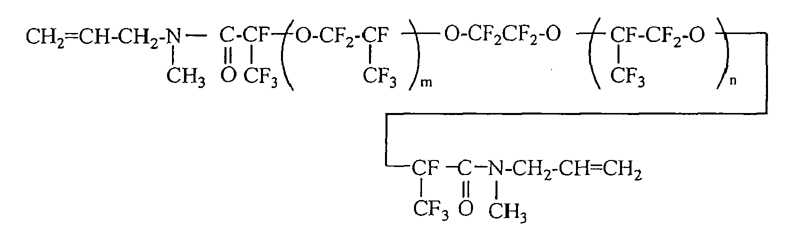 Note that each of m and n is an integer of 0 to 200.

In the practice of the invention, to modify the linear fluoropolyether compound of formula (1) to the desired weight-average molecular weight in accordance with the intended use, the linear fluoropolyether compound may be previously subjected to hydrosilylation with an organosilicon compound containing two SiH groups per molecule by an ordinary method and under ordinary conditions. The resulting chain-extended product can be used as component (A).

The linear perfluoropolyether compound of formula (1) should desirably have a weight-average molecular weight (Mw) of 2,000 to 100,000, and most preferably 4,000 to 50,000. Compounds with Mw of less than 2,000 undergo substantial swell in DME and other solvents, as demonstrated by a swelling degree of at least 20% in DME and a swelling degree of at least 6% in gasoline, failing to meet the requirements of parts that must be resistant to DME or gasoline. Compounds with Mw of more than 100,000 are too viscous to work, detracting from practical utility. Upper and lower limits are independent.

### Component B

Component (B) serves as a crosslinking agent for component (A). Component (B) is any organosilicon compound as long as it has at least three silicon atom-bonded hydrogen atoms in a molecule. Organosilicon compounds of the general formula (2) are preferred. 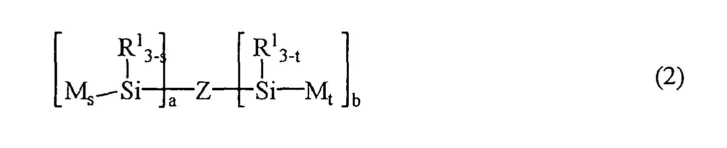 Herein, each of a and b is equal to 0 or 1, excluding the case where a and b are 0 at the same time. In the event where one of a and b is 0 and the other is 1, Z is hydrogen, -Q-M or -Q-Rf. In the event where both a and b are 1, Z is -Q-, -Rf'- or -Q-Rf'-Q-. M is a group of the following formula. 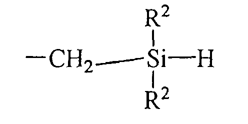 Q is a divalent hydrocarbon group which may contain an ether bond. Rf is a perfluoroalkyl or perfluorooxyalkyl group. Rf' is a perfluoroalkylene or perfluorooxyalkylene group. R¹ and R² which may be the same or different are monovalent hydrocarbon groups of 1 to 10 carbon atoms. The letter s is 1, 2 or 3, and t is 0, 1, 2 or 3.

Specifically, each of R¹ and R² is independently a monovalent hydrocarbon group of 1 to 10 carbon atoms, for example, alkyl groups such as methyl, ethyl, propyl, isopropyl, butyl, isobutyl, tert-butyl, pentyl, hexyl, octyl and decyl; cycloalkyl groups such as cyclopentyl, cyclohexyl and cycloheptyl; alkenyl groups such as vinyl, allyl, propenyl, isopropenyl, butenyl and hexenyl; aryl groups such as phenyl, tolyl, xylyl and naphthyl; and aralkyl groups such as benzyl, phenylethyl, phenylpropyl. Of these, those free of aliphatic unsaturation are preferred.

Q is a divalent hydrocarbon group of 2 to 20 carbon atoms which may contain an ether bond. Such divalent linking groups include alkylene groups, arylene groups, and combinations thereof, which may be separated by an ether-bonding oxygen atom, an amide bond, a carbonyl bond or the like, with those of 2 to 12 carbon atoms being preferred. Examples of suitable divalent linking groups are:

-CH₂CH₂-,

-CH₂CH₂CH₂-,

-CH₂CH₂CH₂OCH₂-,

-CH₂CH₂CH₂-NH-CO-,

-CH₂CH₂CH₂-N(Ph)-CO-,

-CH₂CH₂CH₂-N(CH₃)-CO-,

and

-CH₂CH₂CH₂-O-CO-.

Note that Ph is phenyl.

Illustrative examples of the organosilicon compound (B) are given below. Note that Me is methyl and Ph is phenyl.

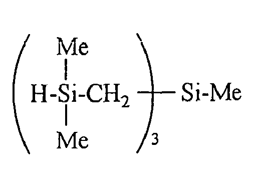

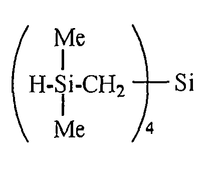

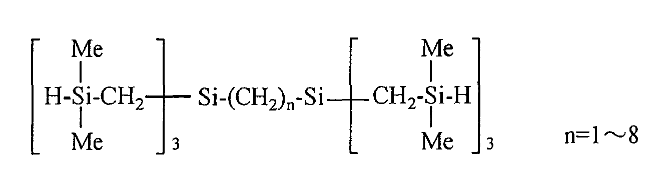

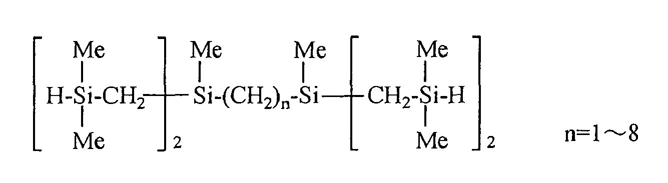

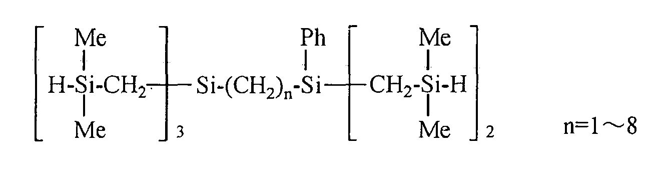

When compatibility with and dispersion in component (A) and uniformity after curing are taken into account, the organosilicon compound should preferably have in a molecule at least one perfluoroalkyl or perfluorooxyalkyl group represented by Rf and/or at least one perfluoroalkylene or perfluorooxyalkylene group represented by Rf'.

Examples of such perfluoroalkyl, perfluorooxyalkyl, perfluoroalkylene and perfluorooxyalkylene groups include those of the following general formulae.

Perfluoroalkyl groups: C_{g}F_{2g+1}-

Letter g is an integer of 1 to 20, preferably 2 to 10.

Perfluoroalkylene groups: -C_{g}F_{2g}-

Letter g is an integer of 1 to 20, preferably 2 to 10.

Perfluorooxyalkyl groups:

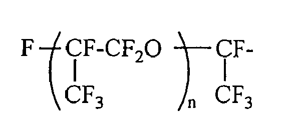

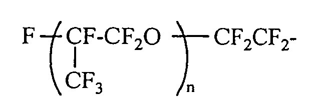

Letter n is an integer of 1 to 5.

Perfluorooxyalkylene groups:

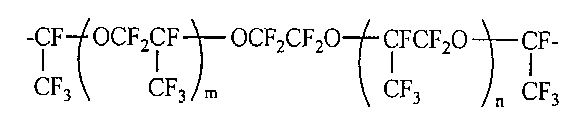

The sum of m+n is an integer of 1 to 200.

- (CF₂O)ₘ-(CF₂CF₂O)ₙ-CF₂-

Each of m and n is an integer of 1 to 50.

These perfluoro(oxy)alkyl and perfluoro(oxy)alkylene groups may be bonded to silicon atoms directly or via a divalent linking group Q. The divalent linking group Q used herein may be the same as described above.

When the organosilicon compounds (B) contain monovalent fluorinated substituent groups and silicon-bonded monovalent substituent groups of R¹ and R², suitable substituent groups of R¹ and R² include hydrocarbon groups of 1 to 10 carbon atoms as exemplified above.

No particular limitation is imposed on the number of silicon atoms per molecule in the organosilicon compound, although it is generally about 2 to about 60, and preferably about 3 to about 30.

Illustrative examples of these organosilicon compounds include compounds of the following formulae wherein Me stands for methyl. These compounds may be used alone or in admixture. 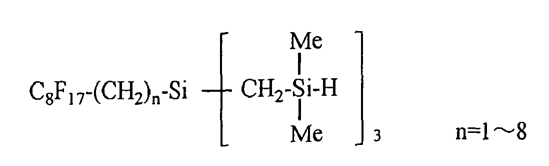 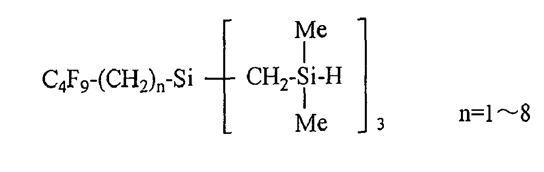 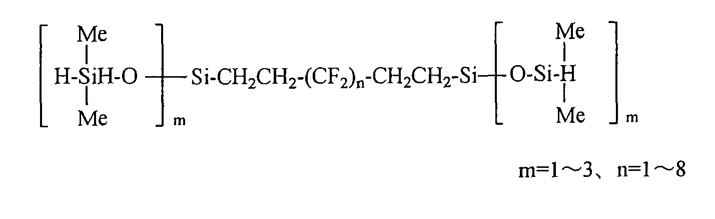 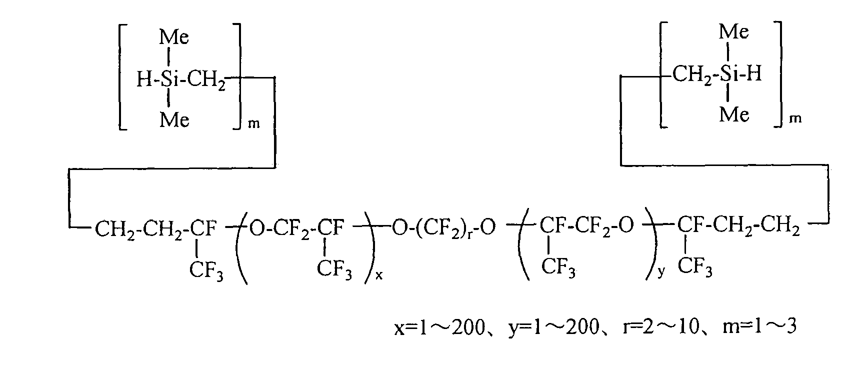 Note that m and n each are an integer of 0 to 200, and the sum of m+n ranges from 50 to 200.

Component (B) is generally included in such an amount as to supply preferably 0.5 to 5 moles, and more preferably 1 to 2 moles, of hydrosilyl (SiH) groups per mole of alkenyl groups (e.g., vinyl, allyl) on component (A). Too little component (B) may lead to an inadequate degree of crosslinking, whereas too much may favor chain extension at the expense of curing, may result in foaming, or may be detrimental to heat resistance, compressive set and other properties.

### Component C

Component (C) is a hydrosilylation catalyst which is generally selected from transition metals, for example, platinum group metals such as Pt, Rh and Pd and compounds of transition metals. Typical are noble metal compounds which are expensive. Platinum and platinum compounds are thus used because they are readily available.

Exemplary platinum compounds include, but are not limited to, chloroplatinic acid, complexes of chloroplatinic acid with olefins such as ethylene, complexes of chloroplatinic acid with alcohols and vinylsiloxanes, and metallic platinum supported on silica, alumina or carbon. Known platinum group metal compounds other than the platinum compounds include rhodium, ruthenium, iridium, and palladium compounds, for example, RhCl(PPh₃)₃, RhCl(CO)(PPh₃)₂, RhCl(C₂H₄)₂, Ru₃(CO)₁₂, and IrCl(CO)(PPh₃)₂ wherein Ph denotes phenyl.

The amount of the hydrosilylation catalyst used is not particularly limited because an ordinary catalytic amount achieves a desired curing rate. From the economical standpoint and for satisfactory cured properties, the catalyst is preferably added in an amount to give 0.1 to 1,000 ppm, more preferably 0.1 to 500 ppm of platinum group metal based on the total weight of the curable composition except component (C).

### Component D

In the curable perfluoropolyether gel composition, a polyfluoromonoalkenyl compound containing one alkenyl group per molecule and having a perfluoropolyether structure in its backbone may be included as component (D). The preferred polyfluoromonoalkenyl compound has the general formula (3):

Rf¹-(X')ₚ-CH=CH₂ (3)

wherein X' and p are as defined above, and Rf¹ has the formula: F-[CF(CF₃)CF₂O]_{w}-CF(CF₃)- wherein w is an integer of 1 to 500.

Illustrative, non-limiting examples of the polyfluoromonoalkenyl compound having formula (3) are given below.

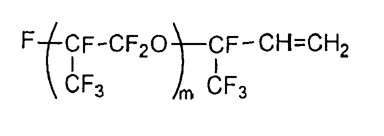

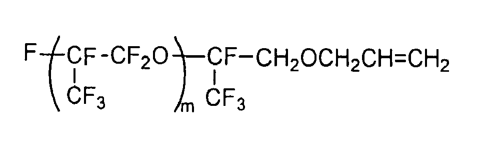

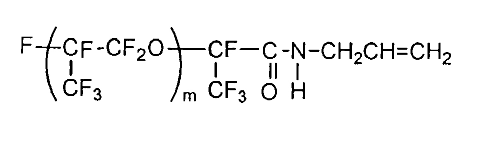

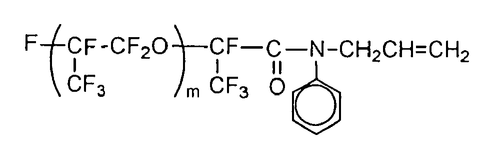

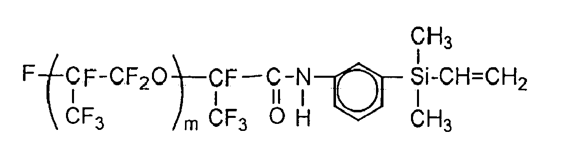

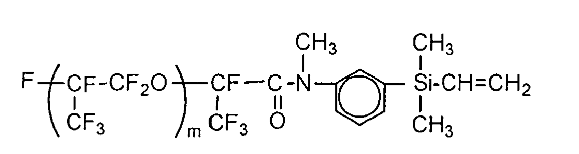

In the curable perfluoropolyether gel composition, the polyfluoromonoalkenyl compound having formula (3) is preferably included in an amount of 1 to 300 parts by weight, more preferably 50 to 250 parts by weight per 100 parts by weight of the linear perfluoropolyether dialkenyl compound (A).

### Component E

The perfluoropolyether rubber or gel composition of the invention may further include (E) an alkenyl-free, non-functional fluoro-polymer having a perfluoropolyether structure comprising recurring units of -CₐF₂ₐO- wherein "a" is an integer of 1 to 6. The non-functional fluoro-polymer is preferably linear.

The linear perfluoropolyether compound (E) is included to impart chemical resistance, solvent resistance and low-temperature properties to the composition without detracting from physical properties. Particularly when the linear perfluoropolyether compound (E) is included in the perfluoropolyether rubber or gel composition, it is effective for imparting improved low-temperature properties, typically lowering the glass transition temperature.

The preferred linear perfluoropolyether compounds include compounds having the general formula (4):

A-O-(CF₂CF₂CF₂O)_{d}-A (4)

wherein A is a group of the formula: CₑF₂ₑ₊₁-, d is an integer of 1 to 500, and e is an integer of 1 to 3, and compounds having the general formula (5):

A-O-(CF₂O)_{f}(CF₂CF₂O)ₕ-A (5)

wherein A is as defined above and f and h each are an integer of 1 to 300.

Illustrative examples of linear perfluoropolyether compounds (E) include

CF₃O-(CF₂CF₂CF₂O)_{n'}-CF₂CF₃

and

CF₃- [(OCF₂CF₂)_{n'}(OCF₂)_{m'}]-O-CF₃

wherein m' is an integer of 1 to 200, n' is an integer of 1 to 200, and the sum of m'+n' ranges from 1 to 200.

An appropriate amount of component (E) compounded varies whether the perfluoropolyether composition is a rubber or gel composition. In the perfluoropolyether gel composition, the preferred amount of component (E) is 20 to 100 parts by weight per 100 parts by weight of components (A) and (D) combined, that is, polyfluorodialkenyl compound plus polyfluoromonoalkenyl compound. In the perfluoropolyether rubber composition, the preferred amount of component (E) is 10 to 50 parts by weight per 100 parts by weight of component (A). As component (E), the linear perfluoropolyether compounds may be used alone or in admixture.

### Other components

If necessary, various additives may be added to the curable composition of the invention to enhance its usefulness. Suitable additives include polysiloxanes containing CH₂=CH(R)SiO units (wherein R is a hydrogen atom or a substituted or unsubstituted monovalent hydrocarbon group) (see JP-B 48-10947) and acetylene compounds (see U.S. Patent No. 3,445,420 and JP-B 4-3774) which are added to control the curing rate of the curable composition, and ionic compounds of heavy metals (see U.S. Patent No. 3,532,649).

Suitable hydrosilylation catalyst regulators include acetylenic alcohols such as 1-ethynyl-1-hydroxycyclohexane, 3-methyl-1-butyn-3-ol, 3,5-dimethyl-1-hexyn-3-ol, 3-methyl-1-penten-3-ol and phenylbutynol; 3-methyl-3-penten-1-yne and 3,5-dimethyl-3-hexen-1-yne; polymethylvinylsiloxane cyclic compounds; and organophosphorus compounds. The addition of such regulators keeps appropriate cure reactivity and shelf stability.

The curable composition of the invention may also have added thereto fillers for the purposes of reducing heat shrinkage during curing, lowering the thermal expansion coefficient of the elastomer obtained by curing the composition, enhancing the thermal stability, weatherability, chemical resistance, flame retardance and mechanical strength of the elastomer, and decreasing the gas permeability of the elastomer. Examples of such fillers include fumed silica, quartz flour, glass fibers, carbon, metal oxides such as titanium oxide, and metal carbonates such as calcium carbonate. If necessary, suitable pigments and dyes may also be added.

Suitable inorganic fillers include fumed silica, fused silica, crystalline silica, iron oxide, zinc oxide, titanium oxide, calcium carbonate, magnesium carbonate, zinc carbonate, and carbon black. The addition of such inorganic fillers adjusts the hardness or mechanical strength of cured products of the compositions. Hollow inorganic fillers or spherical rubbery fillers are also useful.

To impart adhesion, any of well-known tackifiers having epoxy, alkoxy or similar groups may be added. These additives may be used in any desired amounts as long as they do not interfere with properties of the compositions or properties of the cured products.

### Preparation and curing

The method of preparing the curable composition of the invention is not critical. The composition may be formulated as a single composition by compounding all the essential components. Alternatively, the composition is formulated into two packs containing components (A) and (B) separately where the two packs are mixed together on use.

The composition will cure at room temperature depending on the type of functional group on component (A) and the type of catalyst (C). Often and preferably, the composition is cured by heating at 100 to 200°C for several minutes to several hours.

Prior to use, the curable composition of the invention may be dissolved in a suitable fluorochemical solvent such as 1,3-bistrifluoromethylbenzene or perfluorooctane to a suitable concentration, depending on a particular application or purpose intended.

The cured perfluoropolyether rubber can be formed by combining 100 parts by weight of component (A) with an amount of component (B) to provide 0.2 to 2.0 moles of hydrosilyl groups per mole of total alkenyl groups in component (A), and an amount of component (C) to provide 0.1 to 100 ppm of platinum relative to the total weight of components (A) and (B). To the mix, 10 to 50 parts by weight of component (E) may be added if desired for reducing the glass transition temperature.

The cured rubber is formed by any of prior art well-known techniques, for example, by casting the composition into a suitable mold and causing the composition to cure therein, by coating the composition onto a suitable substrate and curing it thereto, or by lamination. The curing is readily achieved by heating at a temperature of about 60 to about 150°C for about 30 to about 180 minutes.

The rubber thus cured is typically a rubber material having a hardness of 10 to 80 according to JIS K6253 and a glass transition temperature of up to -50°C.

The cured perfluoropolyether gel can be formed by combining 25 to 65 parts by weight of component (A) with 75 to 35 parts by weight of component (D), an amount of component (B) to provide 0.2 to 2.0 moles of hydrosilyl groups per mole of total alkenyl groups in components (A) and (D), and an amount of component (C) to provide 0.1 to 100 ppm of platinum relative to the total weight of components (A), (B) and (D). To the mix, 20 to 100 parts by weight of component (E) may be added if desired for reducing the glass transition temperature.

The cured gel is formed by any of prior art well-known techniques, for example, by casting the composition into a suitable mold and causing the composition to cure therein, by coating the composition onto a suitable substrate and curing it thereto, or by lamination. The curing is readily achieved by heating at a temperature of about 60 to about 150°C for about 30 to about 180 minutes.

The gel thus cured is typically a gel material having a penetration of 10 to 150 according to the consistency test (using a 1/4 cone) of JIS K2220 or ASTM D-1403 and a glass transition temperature of up to -50°C.

The perfluoropolyether rubber or gel compositions of the invention cure into satisfactory products having good heat resistance, chemical resistance, solvent resistance, water repellency, oil repellency and weatherability and especially low gas permeability, typically minimal permeability to acidic gases and thus finding a variety of applications.

Rubber or gel articles comprising the cured perfluoropolyether rubber or gel compositions of the invention are suitable for use in a variety of applications, for example, automobiles, chemical plants, ink jet printers, semiconductor manufacturing lines, analytical or scientific instruments, medical equipment, aircraft, and fuel cells.

More specifically, rubber articles comprising the cured fluoropolyether rubber compositions of the invention include, but are not limited to, rubber parts for automobiles, for example, diaphragms such as fuel regulator diaphragms, pulsation damper diaphragms, oil pressure switch diaphragms, and EGR diaphragms, valves such as canister valves and power control valves, O-rings such as quick connector O-rings and injector O-rings, and seals such as oil seals and cylinder head gaskets; rubber parts for chemical plants, for example, pump diaphragms, valves, O-rings, packings, oil seals, and gaskets; rubber parts for power plants, for example, pump diaphragms, O-rings, packings, valves, and gaskets; sealing parts for fuel cells; electric moisture-proof coating materials; sensor potting materials; and rubber parts for aircraft, for example, O-rings, face seals, packings, gaskets, diaphragms, and valves.

When the inventive compositions are potted or coated onto substrates to form cured products thereon, it is advantageous to use conventional primers in order to improve the bond or adhesion of the inventive compositions to substrates. The use of primers prevents penetration of chemicals and solvents from the substrate interface, and improves the acid resistance, chemical resistance and solvent resistance of entire parts.

As the primer, use may be made of silane primers based on silane coupling agents, organohydrogenpolysiloxane-based primers, synthetic rubber-based primers, acrylic resin-based primers, urethane resin-based primers, and epoxy resin-based primers. The perfluoropolyether rubber composition of the invention having a tackifier added thereto is also useful as the primer.

### EXAMPLE

Examples are given below by way of illustration and not by way of limitation. Note that all parts are by weight; and Me is methyl.

### Example 1

20 parts of fumed silica treated with dimethylsiloxy groups and having a specific surface area of 200 m²/g and 0.5 part of carbon powder were added to 100 parts of a fluoro-polymer of the following formula. 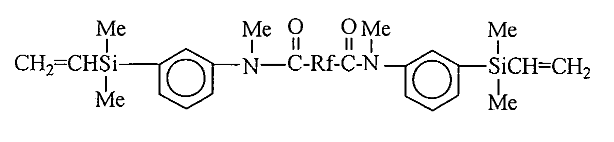 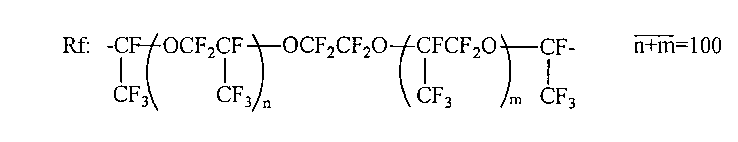 They were heat treated and milled on a three-roll mill. To the mixture were added 3.0 parts of a fluorinated organosilicon compound of the formula: 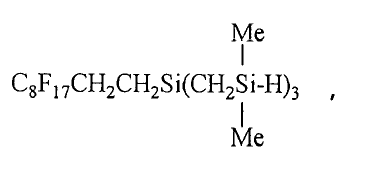 0.2 part of a toluene solution of a catalyst in the form of chloroplatinic acid modified with CH₂=CHSiMe₂OSiMe₂CH=CH₂ (platinum concentration 1.0 wt%) and 0.3 part of a 50 wt% toluene solution of ethynyl cyclohexanol. They were mixed to form a composition.

The composition was deaerated in vacuo, cast into a rectangular frame of 2 mm thick, deaerated again, press cured at 100 kg/cm² and 150°C for 10 minutes, and post cured at 200°C for 4 hours. A test specimen was cut from the cured sample and measured for normal physical properties. The test specimen was further examined for heat resistance, DME swell and freeze resistance. The results are shown in Table 1.

The test conditions are described below.
(1) Normal physical properties
   hardness and elongation: JIS K6253
   tensile strength: JIS K6251
(2) DME resistance: JIS K6258
   volume swell after immersion at 25°C, 0.6 MPa
(3) Heat resistance: JIS K6257
   a change of tensile strength after heating at 200°C for 100 hours
(4) Freeze resistance: JIS K6261
   TR-10
[JIS standards are as in effect at the present priority date.]

### Example 2

A cured sample was prepared as in Example 1 aside from using a fluoro-polymer of the formula shown below. A test specimen similarly prepared was measured for normal physical properties and further examined for heat resistance, DME swell and freeze resistance, with the results shown in Table 1.

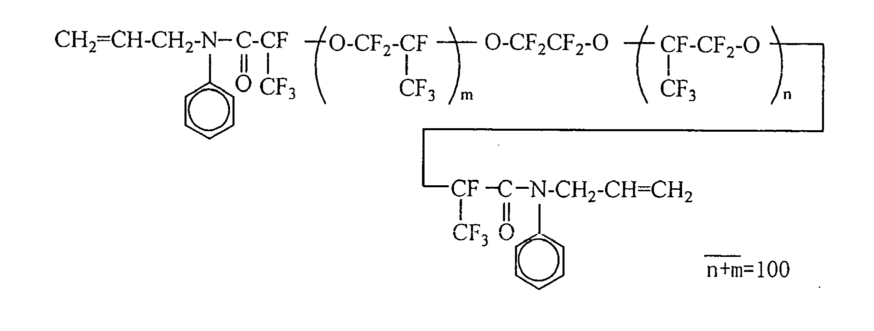

### Comparative Example 1

A cured sample was prepared as in Example 1 aside from using 100 parts of a fluoro-polymer of the formula shown below. A test specimen similarly prepared was measured for normal physical properties and further examined for heat resistance, DME swell and freeze resistance, with the results shown in Table 1.

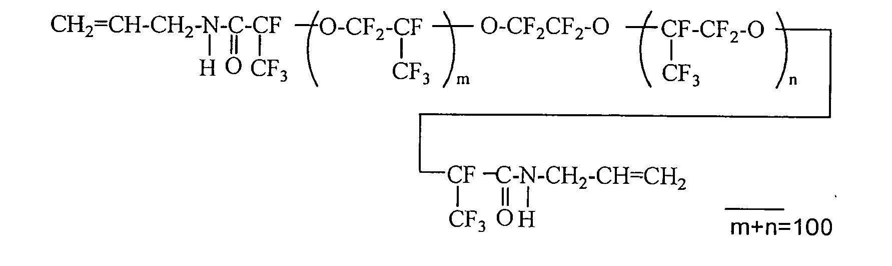

### Comparative Example 2

A test specimen was prepared by using a perfluoroelastomer FFKM (Kalrez^{®} 1050LF by DuPont) and vulcanizing with peroxide. It was measured as in Example 1, with the results shown in Table 1.

### Comparative Example 3

A test specimen was prepared by using a fluoroelastomer FKM (Viton^{®} E-60C by DuPont) and vulcanizing with polyol. It was measured as in Example 1, with the results shown in Table 1.

**Table 1**

| Physical properties | | Example | | Comparative Example | | |
|---|---|---|---|---|---|---|
| | | 1 | 2 | 1 | 2 | 3 |
| Normal physical properties | Hardness (Durometer A) | 50 | 51 | 49 | 82 | 72 |
| | Elongation (%) | 460 | 380 | 455 | 135 | 195 |
| | Tensile strength (MPa) | 10.3 | 9.8 | 10.1 | 16.9 | 15.1 |
| DME resistance | Volume swell (%) | +9 | +10 | +10 | +6 | >100 |
| Heat resistance | Tensile strength change (%) @200°C/100hr | -4 | -6 | -50 | -2 | -3 |
| Freeze resistance | TR-10 (°C) | -50 | -51 | -49 | -6 | -18 |

Both the compositions of Examples 1 and 2 exhibit excellent DME resistance, heat resistance and freeze resistance. Comparative Examples 1 to 3 are previously used as fuel-related sealing materials, but none of them satisfy all the properties of DME resistance, heat resistance and freeze resistance. Specifically, Comparative Example 1 is good in DME resistance and freeze resistance, but lacks heat resistance because the structure of the linear polyfluoro compound (A) deviates from formula (1). Comparative Example 2 is good in DME resistance and heat resistance, but lacks freeze resistance. Comparative Example 2 is good in heat resistance, but lacks DME resistance and freeze resistance.

## Claims

1. A fluorine-containing material consisting of a rubber or gel obtained by crosslinking of a curable composition and having a swelling degree of up to 20% in dimethyl ether,
said curable composition comprising
(A) linear polyfluoro compound containing two alkenyl groups per molecule and having a perfluoropolyether structure in its backbone, represented by the formula (1): 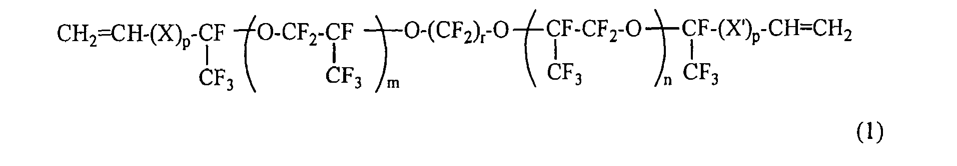 wherein X is -CH₂- or -Y-NR-CO- wherein Y is -CH₂- or a dimethylphenylsilylene group of the following structural formula (Z): 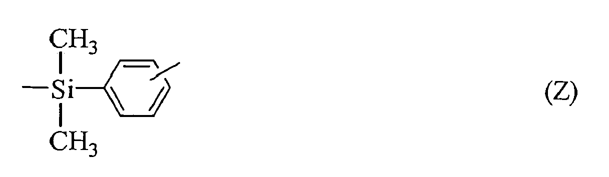 (inclusive of o-, m- and p-positions) and R is methyl or phenyl,
X' is -CH₂- or -CO-NR'-Y'- wherein Y' is -CH₂- or a dimethylphenylsilylene group of the following structural formula (Z'): 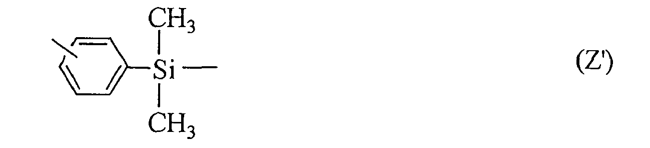 (inclusive of o-, m- and p-positions) and R' is methyl or phenyl,
p is independently 0 or 1, r is an integer of 2 to 6, and m and n each are an integer of 0 to 200,
(B) fluorinated organopolysiloxane having at least three hydrogen atoms directly bonded to silicon atoms in a molecule, and
(C) hydrosilylation catalyst.

2. The fluorine-containing material of claim 1 which undergoes a change of tensile strength of up to 10% in a 200°C/100 hour heating test.

3. A fluorine-containing material of claim 1 consisting of a gel material obtained by crosslinking of a curable composition and having a swelling degree of up to 20% in dimethyl ether,
said curable composition comprising
(A) linear polyfluoro compound containing two alkenyl groups per molecule and having a perfluoropolyether structure in its backbone, represented by the formula (1): 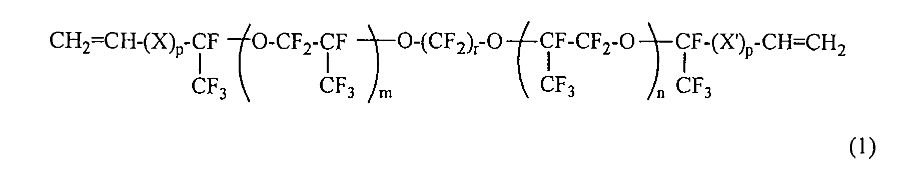 wherein X is -CH₂- or -Y-NR-CO- wherein Y is -CH₂- or a dimethylphenylsilylene group of the following structural formula (Z): 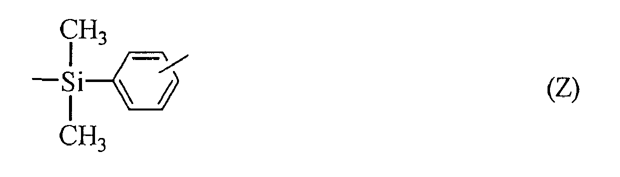 (inclusive of o-, m- and p-positions) and R is methyl or phenyl,
X' is -CH₂- or -CO-NR'-Y'- wherein Y' is -CH₂- or a dimethylphenylsilylene group of the following structural formula (Z'): 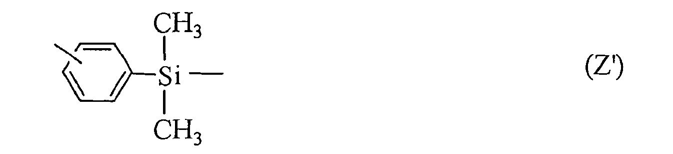 (inclusive of o-, m- and p-positions) and R' is methyl or phenyl,
p is independently 0 or 1, r is an integer of 2 to 6, and m and n each are an integer of 0 to 200,
(B) fluorinated organopolysiloxane having at least three hydrogen atoms directly bonded to silicon atoms in a molecule,
(C) hydrosilylation catalyst, and
(D) polyfluoromonoalkenyl compound having the general formula (3):
Rf¹-(X')ₚ-CH=CH₂ (3)
wherein X' and p are as defined above, and Rf¹ has the formula: F-[CF(CF₃)CF₂O]_{w}-CF(CF₃)- wherein w is an integer of 1 to 500.

4. The fluorine-containing material of any one of claims 1 to 3 wherein said curable composition further comprises
(E) at least one linear polyfluoro compound selected from compounds having the general formula (4):
A-O-(CF₂CF₂CF₂O)_{d}-A (4)
wherein A is a group of the formula: CₑF₂ₑ₊₁-, d is an integer of 1 to 500, and e is an integer of 1 to 3, and compounds having the general formula (5):
A-O-(CF₂O)_{f}(CF₂CF₂O)ₕ-A (5)
wherein A is as defined above and f and h each are an integer of 1 to 300.

5. An article composed of the fluorine-containing material of any one of claims 1 to 4 for use in automobiles, chemical plants, ink jet printers, semiconductor manufacturing lines, analytical or scientific instruments, medical equipment, aircraft or fuel cells.

6. A pressure sensor for use in automobiles comprising a sensor section for detecting a pressure and generating an electric signal in response to the detected pressure value, and a protective member with chemical resistance covering the sensor section for protection, said protective member comprising the fluorine-containing material of any one of claims 1 to 4.

7. A fuel-related sealing material composed of the fluorine-containing material of any one of claims 1 to 4 for use in automobiles, chemical plants, fuel storage, fuel transportation, fuel cells, power generators, household appliances, and aircraft.

8. A fuel-related sealing material composed of the fluorine-containing material of any one of claims 1 to 4 which is a diaphragm, valve, O-ring, oil seal, gasket or packing.

9. A method comprising curing a curable composition as defined in any one of claims 1 to 4 to form a cured rubber or gel material according to any one of claims 1 to 4, 7, 8 or article according to claim 5 or 6.

10. A curable composition as defined in any one of claims 1 to 4.
